(19) **Europäisches Patentamt / European Patent Office / Office européen des brevets**

(11) **EP 2 872 736 B1**

(12) **EUROPEAN PATENT SPECIFICATION**

(45) Date of publication and mention
of the grant of the patent:
**11.04.2018 Bulletin 2018/15**

(21) Application number: **13826500.4**

(22) Date of filing: **19.07.2013**

(51) Int Cl.:
*E21B 43/12* (2006.01)     *E21B 47/04* (2012.01)
*G06F 17/10* (2006.01)     *E21B 43/16* (2006.01)

(86) International application number:
**PCT/US2013/051385**

(87) International publication number:
**WO 2014/022127 (06.02.2014 Gazette 2014/06)**

(54) **MONITORING AND DIAGNOSING WATER FLOODED RESERVOIRS**

ÜBERWACHUNG UND DIAGNOSE VON WASSERÜBERFLUTETEN RESERVOIRS

SURVEILLANCE ET DIAGNOSTIC DE RÉSERVOIRS À INJECTION D'EAU

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **31.07.2012 US 201261677996 P
07.11.2012 US 201213670836**

(43) Date of publication of application:
**20.05.2015 Bulletin 2015/21**

(73) Proprietor: **Landmark Graphics Corporation
Houston, TX 77042-3021 (US)**

(72) Inventors:
• **CARVAJAL, Gustavo
Katy, TX 77494 (US)**

• **VASHISTH, Dhruv
Houston, TX 77042 (US)**
• **WANG, Feng
Houston, TX 77042 (US)**
• **CULLICK, Alvin, S.
Houston, TX 77042 (US)**
• **MD ADNAN, Nurul, F.
Houston, TX 77042 (US)**

(74) Representative: **Hoffmann Eitle
Patent- und Rechtsanwälte PartmbB
Arabellastraße 30
81925 München (DE)**

(56) References cited:
**US-A1- 2004 124 009     US-A1- 2009 107 669
US-A1- 2010 206 559     US-A1- 2011 040 543
US-B2- 7 672 825**

**Description**

BACKGROUND

Oil field operators dedicate significant resources to improve the recovery of hydrocarbons from reservoirs while reducing recovery costs. To achieve these goals, reservoir engineers both monitor the current state of the reservoir and attempt to predict future behavior given a set of current and/or postulated conditions. Reservoir monitoring, sometimes referred to as reservoir surveillance, involves the regular collection and monitoring of measured near-wellbore production data from within and around the wells of a reservoir. Such data may be collected using sensors installed in-line along production tubing introduced into the well. The data may include, but is not limited to, water saturation, water and oil cuts, fluid pressure and fluid flow rates, and is generally collected at a fixed, regular interval (e.g., once per minute) and monitored in real-time by field personnel. As the data is collected, it is archived into a historical database.

The collected production data, however, mostly reflects conditions immediately around the reservoir wells. To provide a more complete picture of the state of a reservoir, simulations are executed as part of the well surveillance that model the overall behavior of the entire reservoir based on the data collected, both current and historical. These simulations predict the reservoir's overall current state, producing simulated interwell data values both near and at a distance from the wellbore. Simulated near-wellbore interwell data is regularly correlated against measured near-wellbore data, with modeling parameters being adjusted as needed to reduce the error between the simulated and measured data. Once so adjusted, the simulated interwell data, both near and at a distance from the wellbore, may be relied upon to assess the overall state of the reservoir.

Simulation models are also used to predict the future behavior of the reservoir based upon reservoir conditions input by an operator of the simulator. These conditions may be current conditions as measured and/or simulated during surveillance of the well, or theoretical conditions input by the user to see how changes may affect future production. For example, where enhanced oil recovery (EOR) operations are planned or are already being implemented, changes in the placement and operation of injector and producer wells can be evaluated both before operations begin and as a reservoir's production progresses.

Reservoir simulations, particularly those that perform full-physics numerical simulations on large reservoirs, are computationally intensive and can take hours, even days to execute. This is due to both the complexity of the simulation and the enormous amount of data being processed. Because of this, it is not unusual for full reservoir simulations to only be run once a month. As a result, the full impact of operational changes made to a reservoir (e.g., changes in water injection rates in an EOR operation) may not be known for up to a month. Further, simulations are typically run by engineers who analyze the simulated interwell data at an office rather than while in the field, while field personnel rely primarily on measured near-wellbore data to monitor the current reservoir state. Both engineering and field personnel could benefit by having both datasets (simulated interwell data and measured near-wellbore data) presented in a manner that correlates them in a meaningful manner to assist with assessing the overall state of a reservoir.

US 2009/0107669 A1 discloses a method of analyzing waterflooding of a subterranean formation, wherein near wellbore data are processed in a reservoir simulation step to yield simulated interwell data. Production indicators are derived from the interwell data and remedial actions carried out if the production indicators fall outside a threshold range.

US 2011/0040543 A1 discloses a virtual reservoir sensor.

SUMMARY OF THE INVENTION

In a first aspect of the present invention, there is provided a method according to Claim 1.

In a second aspect of the present invention, there is provided a system according to Claim 9.

BRIEF DESCRIPTION OF THE DRAWINGS

A better understanding of the various disclosed exemplary embodiments can be obtained when the following detailed description is considered in conjunction with the attached drawings, in which:

FIG. 1 shows a production well with instrumentation that sources measured near-wellbore data suitable for monitoring and diagnosing a reservoir;

FIG. 2 shows an illustrative reservoir monitoring and diagnosing map with indicator gauges;

FIG. 3 shows an illustrative data flow of reservoir production data;

FIG. 4 shows an illustrative reservoir monitoring and diagnosing method; and

FIG. 5 shows an illustrative data acquisition and processing system suitable for implementing software-based embodiments of the systems and methods described herein.

It should be understood that the drawings and corresponding detailed description do not limit the disclosure, but on the contrary, they provide the foundation for understanding all modifications, equivalents, and alternatives falling within the scope of the present disclosure.

DETAILED DESCRIPTION

The paragraphs that follow describe various illustrative systems and methods for monitoring and diagnosing reservoirs (e.g., oil and gas reservoirs) using near-wellbore production data collected from, and production indicators associated with, wells within the reservoirs. An illustrative production well suitably configured for collecting measured near-wellbore production data is first described, followed by a description of a reservoir map produced from the collected data using the disclosed system and methods. A high level flow diagram of the near-wellbore production data and the data's integration into the reservoir monitoring and diagnosing process is then described, together with a method for performing reservoir monitoring and diagnosing. Finally, a data acquisition and processing system suitable for processing measured near-wellbore production data and performing software-based embodiments of the disclosed methods is described in detail.

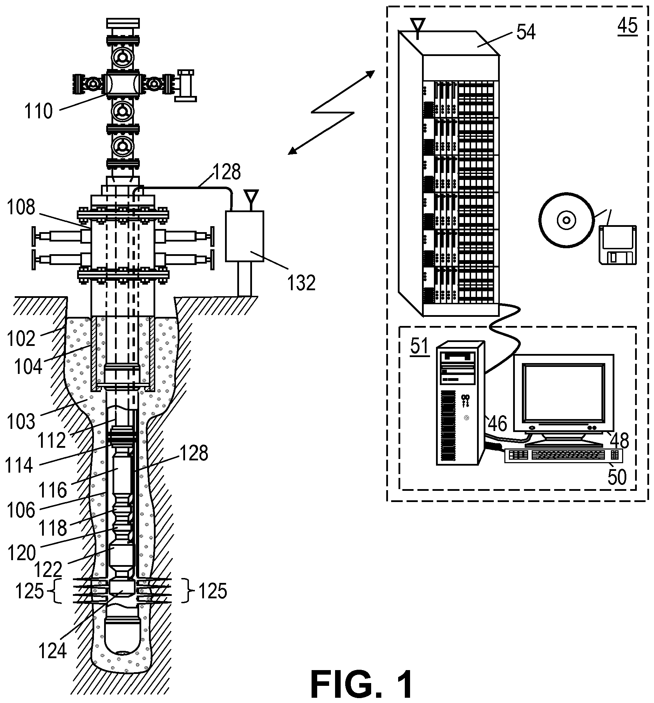

The systems and methods described herein operate on measured near-wellbore data collected from wells within a reservoir, such as that found in oil and gas production fields. Such fields generally include multiple producer wells that provide access to the reservoir fluids underground. Measured near-wellbore data is collected regularly from each producer well to track changing conditions in the reservoir. FIG. 1 shows an example of a producer well with a borehole 102 that has been drilled into the earth. Such boreholes are routinely drilled to ten thousand feet or more in depth and can be steered horizontally for perhaps twice that distance. The producer well also includes a casing header 104 and casing 106, both secured into place by cement 103. Blowout preventer (BOP) 108 couples to casing header 106 and production wellhead 110, which together seal in the well head and enable fluids to be extracted from the well in a safe and controlled manner.

The use of measurement devices permanently installed in the well facilitates monitoring the well. The different transducers send signals to the surface that may be stored, evaluated and used to monitor the well's operations. Measured near-wellbore measurements are periodically taken at the producer well and combined with measurements from other wells within a reservoir, enabling the overall state of the reservoir to be monitored, simulated and assessed. These measurements may be taken using a number of different downhole and surface instruments, including but not limited to, temperature and pressure sensor 118 and flow meter 120. Additional devices also coupled in-line along production tubing 112 include downhole choke 116 (used to vary the fluid flow restriction), electric submersible pump (ESP) 122 (which draws in fluid flowing from perforations 125 outside ESP 122 and production tubing 112) ESP motor 124 (driving ESP 122), and packer 114 (isolating the production zone below the packer from the rest of the well). Additional surface measurement devices may be used to measure, for example, the tubing head pressure and the electrical power consumption of ESP motor 124. Although the example of FIG. 1 shows a well that incorporates an ESP, the disclosed systems and methods may also be used with wells that incorporate other systems for assisting with the extraction of fluids (e.g., gas lift systems), or with wells without such assist systems that rely on the pressure already present in the formation and/or induced by the injector wells.

Each of the devices along production tubing 112 couples to cable 128, which is attached to the exterior of production tubing 112 and is run to the surface through blowout preventer 108 where it couples to control panel 132. Cable 128 provides power to the devices to which it couples, and further provides signal paths (electrical, optical, etc.,) that enable control signals to be directed from the surface to the downhole devices, and for telemetry signals to be received at the surface from the downhole devices. The devices may be controlled and monitored locally by field personnel using a user interface built into control panel 132, or may be controlled and monitored by a computer system 45. Communication between control panel 132 and computer system 45 may be via a wireless network (e.g., a cellular network), via a cabled network (e.g., a cabled connection to the Internet), or a combination of wireless and cabled networks.

Continuing to refer to the example of FIG. 1, control panel 132 includes a remote terminal unit (RTU) which collects the data from the downhole measurement devices and forwards it to a supervisory control and data acquisition (SCADA) system that is part of computer system 45. In the illustrative embodiment shown, computer system 45 includes a set of blade servers 54 with several processor blades, at least some of which provide the above-described SCADA functionality. Other processor blades may be used to implement the disclosed reservoir monitoring and diagnosing. Computer system 45 also includes user workstation 51, which includes a general processing system 46. Both the processor blades of blade server 54 and general processing system 46 are preferably configured by software, shown in FIG. 1 in the form of removable, non-transitory (i.e., non-volatile) information storage media 52, to process collected well and ESP data. The software may also be downloadable software accessed through a network (e.g., via the Internet). General processing system 46 couples to a display device 48 and a user-input device 50 to enable a human operator to interact with the system software 52. Alternatively, display device 48 and user-input device 50 may couple to a processor blade within blade server 54 that operates as general processing system 46 of user workstation 51.

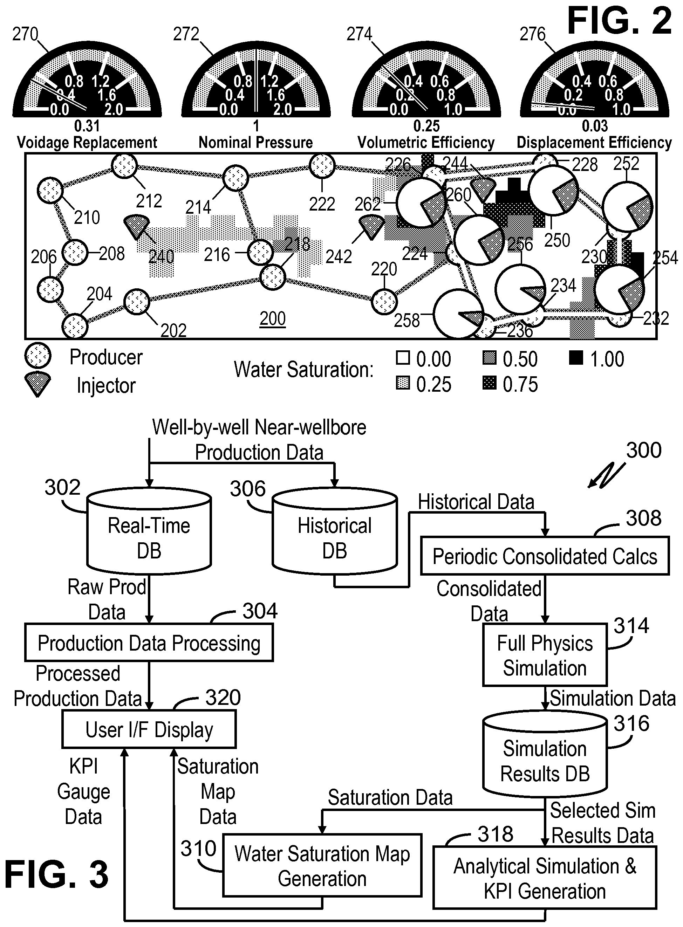

The measured near-wellbore data acquired from the wells may be processed by the above-described software as described in more detail below to produce a summary display of reservoir conditions. The acquired data may be processed and/or displayed in real-time, which is understood to mean happening as the data is acquired. Generally, delays of up to several minutes may be considered as being within the scope of "real-time" processing. The data may be stored (as acquired or in processed form) as historical data for later use and additional processing. The illustrative display shown in FIG. 2 includes a reservoir map 200 that presents the location of injector wells 240-244 and producer wells 202-236 over a shaded background. Injector wells inject fluids into the reservoir to help force the oil and gas in the reservoir out the producer well. Although water is commonly injected, other fluids and/or gases such as $CO_2$ may be used instead of, or in addition to, water. In the example shown, water is used as the injection fluid and the shading of the background reflects the reservoir's water saturation according to the legend shown below map 200, which varies over different regions of the map. The background water saturation data displayed is based upon simulation results that predict the overall interwell reservoir state.

Each injector well and one or more producer wells defines a group referred to as a "pattern", with some producer wells belonging to more than one pattern. In the illustrative example shown in FIG. 2, three patterns are defined: the first including injector well 240 and producer wells 202-218; the second including injector well 242 and producer wells 214-226; and the third including injector well 244 and producer wells 224-236. The patterns are outlined by imaginary lines connecting the corresponding producer wells. In at least some illustrative embodiments, when a pattern is selected, the producer wells and corresponding connector lines are highlighted, as shown for the third pattern.

Additionally, pie chart graphics are displayed that reflect oil and water cuts for each producer well. In at least some illustrative embodiments, the pie chart graphics display the data as it is acquired (i.e., in real-time). In FIG. 2, for example, the water cut is reflected by the darker pie slice, which is smaller or large depending on the relative percentage of water flowing from the producer well at the given moment in time being displayed (e.g., at or near the actual moment in time for a real-time display). In at least some embodiments, the exact oil and water cuts for a producer well are displayed when the user moves a cursor (e.g., using a mouse) over a pie chart for the corresponding well. In other embodiments, the user clicks on the pie chart to see the actual oil and water cut values.

In addition to water saturation, oil cut and water cut values, the summary display of FIG. 2 also displays gauges above reservoir map 200 reflecting a selected set of key performance indicators (KPIs) for the selected pattern. In the example shown, these indicators are the voidage replacement ratio, the nominal pressure, volumetric efficiency, and displacement efficiency, each derived from the measured near-wellbore data collected. In at least some illustrative embodiments, shaded and/or highlighted regions on each gauge indicate acceptable and unacceptable ranges of the values displayed by each gauge. The summary display thus presents a combination of both simulated interwell data (near and at a distance from the wellbore) and measured near-wellbore data that assists a user in assessing the overall reservoir conditions.

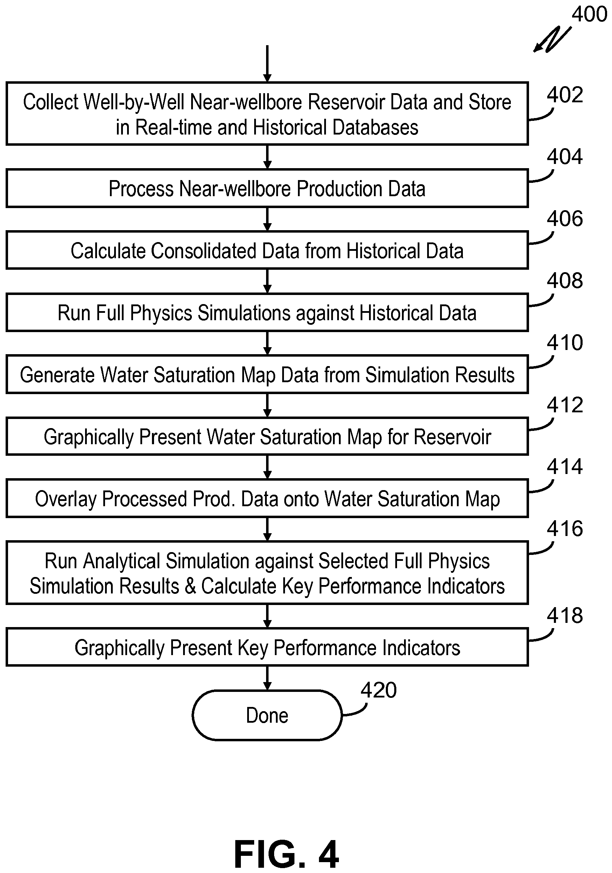

In order to present the above-described reservoir map, the measured near-wellbore data must undergo a significant amount of processing. FIGS. 3 and 4 respectively show an illustrative data flow 300 of the measured near-wellbore data and an illustrative method 400 for processing the data. Measured near-wellbore data is sampled from each of the various wells for one or more patterns and stored in both real-time database (DB) 302 and historical DB 306 of FIG. 3 (block 402, FIG. 4). Raw production data is extracted from real-time DB 302 and provided to production data processing 304 (block 404). This data processing produces instantaneous values for each point in time at which the underlying near-wellbore data was measured. The resulting processed production data may include, for example, water and oil cut data, wellhead pressure and temperature data, and downhole pressure and temperature data. The resulting processed production data is forwarded to user I/F display 320 for later presentation. In at least some illustrative embodiments for example, the water and oil cut data is presented as the reservoir summary oil and water cut pie chart overlays (and values when selected), as shown in FIG. 2. In other illustrative embodiments, well-specific wellhead and downhole pressures and temperature may be overlaid when a well is selected (e.g., by clicking on the well using a mouse). The user may opt to display production data as it is collected in real-time, may opt to display production data at a specific past point in time, or may opt to display a sequence of past production data values to view their progression over time.

Continuing to refer to FIGS. 3 and 4, historical data is similarly extracted from historical DB 306. This data represents data periodically collected over a period of time (e.g., 24 hours, 7 days, one month, etc.) that is aggregated to produce consolidated data (block 406), which includes, but is not limited to the average oil, gas and water produced for the period of time, as well as the average water injection rates over that same period. This consolidated data is forwarded to full-physics numerical simulation 314 (block 408), which produces and stores its results in static full-physics numerical simulation results DB 316. Simulated interwell water saturation data for each simulation cell within the map area to be displayed is extracted from simulation results DB 316 and used by water saturation map generation 310 to generate the reservoir's saturation map (block 410), which is presented via user I/F display 320 as the background of reservoir map 200 of FIG. 2 (block 412). The previously calculated oil/water cut data and/or other processed production data is overlaid onto the resulting reservoir map (block 414). Selected full-physics numerical simulation results data from the full-physics numerical simulation results DB 316 are provided as input to analytical simulation and KPI generation 318. The KPIs include, but are not limited to, the reservoir pressure, the reservoir oil, gas and water flow rates and the reservoir oil, gas and water volumes. While the embodiments of FIGS. 3 and 4 use KPIs (as the term is generally understood in the art), other illustrative embodiments may use other performance indicators, or a combination of KPIs and other performance indicators. In at least some illustrative embodiments, the simulated state of the reservoir at the end of each periodic simulation run (e.g., each monthly run) is saved and later used by the following month's simulation as a reservoir state starting point. Analytical simulation and KPI generation 318 uses the simulation results to produce the KPI gauge data (block 416) forwarded to user I/F display 320 and displayed via the performance indicator gauges of FIG. 2 (block 418), ending method 400 (block 420). The calculations for each of the KPI gauge values are described in more detail below.

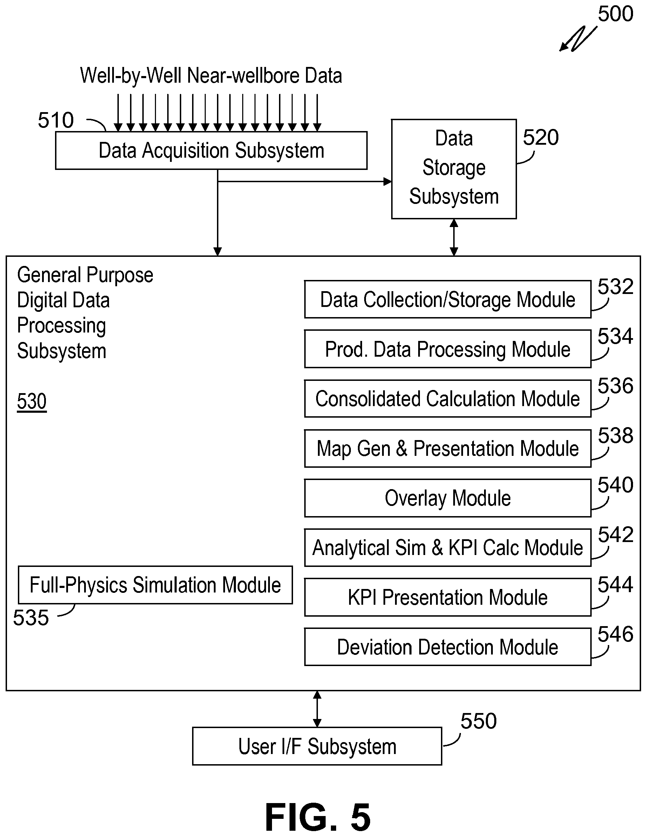

There are a number of different embodiments suitable for implementing method 400, including software-based general purpose computer system 500 of FIG. 5. In the illustrative embodiment shown, measured well-by-well near-wellbore data is provided to data acquisition system 510, which couples to general purpose digital data processing (GPDDP) subsystem 530 and to data storage subsystem 520. The measured near-wellbore data is forwarded to GPDDP subsystem 530 for processing and to data storage subsystem 520 for storage and later retrieval. In at least some illustrative embodiments, data storage subsystem 520 includes the real-time, historical and full-physics numerical simulation results databases of FIG. 3. In other illustrative embodiments, system 500 is located at a datacenter rather than at or near the reservoir, with the measured near-wellbore data being communicated to the data acquisition system via a communication network (e.g., satellite, telecomm or the Internet). GPDDP subsystem 530 also couples to user I/F subsystem 550, which enables a user of the system to interact with the system via such input/output devices as, for example, a keyboard, mouse and display.

In the illustrative embodiment of FIG. 5, software modules are executed by GPDDP subsystem 530 that each performs various portions of method 400 of FIG. 4. Thus, for example, data collection/storage module 532 performs the functions of block 402; production data processing module 534 the functions of block 404; consolidated calculation module 536 the functions of block 406; full-physics numerical simulation module 535 the functions of block 408; map generation and presentation module 538 the functions of blocks 410-412; overlay module 540 the functions of block 414; analytical simulation and KPI calculation module 542 the functions of block 416; and KPI presentation module 544 the functions of block 418.

The illustrative embodiment of FIG. 5 also includes a deviation detection module 546 that monitors the KPIs and generates an alarm if a KPI value deviates from a reference value (e.g., 1.0 for the voidage replacement ratio) by more than a predetermined threshold value (e.g., $\pm 0.1$). In other illustrative embodiments, such a deviation may alternatively or additionally trigger the generation of an advisory that recommends a specific course of action to correct the deviation (e.g., increasing or decreasing the water injection flow rates at one or more injector wells). Some alarms and/or advisories may each be triggered independently when separately defined thresholds are exceeded, while others may be triggered together when a single threshold is exceeded.

Analytical simulation and KPI calculation module 542 uses the results produced by full-physics simulation module 535 to produce each of the performance indicator values displayed by performance indicator gauges 270-276 of FIG. 2. In at least some illustrative embodiments, the performance indicator values of FIG. 2 are calculated as follows:

Voidage Replacement Ratio (either cumulative or instantaneous):

$$VRR = \frac{Vol_{winj}}{Vol_o + Vol_w + Vol_g}, \tag{1}$$

wherein $vol_{winj}$ is the volume of injected water, $vol_o$ is the volume or produced oil, $vol_w$ is the volume of produced water and volg is the volume of produced gas;

Nominal Pressure:

$$P_{nom} = \frac{P_{avg}}{P_{target}}, \tag{2}$$

wherein $P_{avg}$ is the average pressure for the selected pattern and $P_{target}$ is the target reservoir pressure;

Volumetric Sweep Efficiency:

$$E_{vol} = \frac{Cum_o}{OOIP*(1-S_{wp})},$$

(3)

wherein $Cum_o$ is the cumulative oil production in mmstb at a specific point in time, OOIP is the original oil in place in mmstb and $S_{wp}$ is the average water saturation of the selected pattern; and
Displacement Efficiency:

$$E_d = \frac{S_{wp}-S_{wi}}{1-S_{wi}},$$

(4)

wherein $S_{wp}$ is the average water saturation of the selected pattern and $S_{wi}$ is the initial water saturation of the selected pattern.

By combining the measured near-wellbore and simulated interwell data into a single display using the data flow described, reservoir operators can monitor the state of the reservoir, diagnose problems promptly, and assess the effectiveness of corrective action after it is implemented. For example, the voidage replacement ratio can be used to determine if a given pattern needs to receive more or less injected water, and to later assess if the changes made to effect the correction had the desired results. Nominal pressure monitoring can be effective in making sure that the pressure in the reservoir is maintained at the level necessary to exploit the reservoir fluids without unacceptable hydrocarbon losses. Volumetric efficiency monitoring provides a macro indication of how much oil is being replaced by water and thus how efficiently the oil is being swept by the water. Displacement efficiency monitoring is similar to volumetric efficient, but instead provides information at a micro or pore level.

For each performance indicator, the displayed data provides a measure of the state of the reservoir, an indication of issues as they arise, and information that enables a reservoir operator to diagnose and address the issues in a timely manner. If, for example, the nominal pressure reading of a pattern is below a desired range, a reservoir engineer using the disclosed systems and methods can run a series of simulations, using the current simulated reservoir state as a starting point, to test possible solutions intended to raise the nominal pressure of the pattern. Once a solution is identified, the simulated near-wellbore data (e.g., water cut measurements) can be noted and forwarded to field personnel, which may then monitor the measured near-wellbore data after the solution has been applied in the field (e.g., increasing the water injection flow rate at the pattern's injector well) and verify whether the solution is achieving the desired results. This enables operators to take further action promptly if necessary if the solution fails to yield the desire results, rather than a month later after the next regular simulation is run integrating the near-wellbore data collected after implementation of the solution. The ability to concurrently view and correlate measured near-wellbore data and simulated interwell data may thus be used to more efficiently and effectively exploit reservoirs during production.

Numerous other modifications, equivalents, and alternatives, will become apparent to those skilled in the art once the above disclosure is fully appreciated. For example, although at least some software embodiments have been described as including modules performing specific functions, other embodiments may include software modules that combine the functions of the modules described herein. Also, it is anticipated that as computer system performance increases, it may be possible in the future to run the above-described simulations in a much shorter period of time using much smaller hardware, making it possible to perform the simulations more frequently (e.g., weekly or even daily) and using systems on site such as well logging trucks. Additionally, although specific measured near-wellbore values (e.g., water cuts) and simulated overall performance indicators (e.g., nominal pressure) were presented as the monitored and graphically combined values, many other measured near-wellbore and simulated overall values, as well as values calculated and/or derived from the real-time and historical values, may be suitable for producing summary displays similar to the illustrative example of FIG. 2, and all such values and resulting displays are within the scope of the present disclosure. Further, although the term "simulated interwell data" is used to describe simulated data between two or more wells, it is also intended to include simulated data near and/or distanced away from a single well without necessarily being between said well and another well (e.g., simulated data distanced away from a well at the outer edge of a reservoir). It is intended that the following claims be interpreted to embrace all such modifications and alternatives where applicable.

**Claims**

1.    A method for monitoring and diagnosing a reservoir that comprises:

collecting measured near-wellbore data representative of conditions at or near a plurality of wells within the reservoir and storing the measured near-wellbore data in one or more databases;

presenting graphically to a user simulated interwell data generated by a reservoir simulation based at least in part on the measured near-wellbore data;

overlaying graphically at least some of the measured near-wellbore data over the simulated interwell data;

presenting graphically to the user one or more production indicators (270, 272, 274, 276) calculated based at least in part on the simulated interwell data;

determining a deviation of at least one production indicator (270, 272, 274, 276) from a reference value; and

identifying and presenting to the user a recommended action applicable to one or more of the plurality of wells (240, 242) to correct the deviation, if said deviation exceeds a threshold value,

wherein the simulated interwell data includes data near and at a distance from the plurality of wells (240, 242).

2. The method of claim 1, wherein the simulated interwell data comprises water saturation levels.

3. The method of claim 1 or 2, wherein the at least some of the measured near-wellbore data comprises water cuts or oil cuts for each of one or more producer wells (202-218, 214-226, 224-236) of the plurality of wells.

4. The method of claim 1, 2 or 3, wherein the one or more production indicators (270, 272, 274, 276) comprise an indicator selected from the group consisting of a voidage replacement ratio, a nominal pressure, a volumetric sweep efficiency and a displacement efficiency.

5. The method of any preceding claim, further comprising presenting one or more alarms to the user if a production indicator (270, 272, 274, 276) deviates from the or another reference value by more than the or another threshold value.

6. The method of any preceding claim, wherein the overlaying is performed in real-time as the measured near-wellbore data is collected.

7. The method of any preceding claim, further comprising starting the reservoir simulation based at least in part on a stored simulation end state of a prior execution of the reservoir simulation.

8. The method of any preceding claim, further comprising selecting a reservoir pattern comprising the plurality of wells (240, 242), wherein the production indicators (270, 272, 274, 276) presented to the user correspond to one or more wells within the selected pattern.

9. A reservoir monitoring and diagnosing system that comprises:

a memory having reservoir monitoring and diagnosing software; and
one or more processors coupled to the memory, the software causing the one or more processors to:

collect measured near-wellbore data representative of conditions at or near a plurality of wells (240, 242) within the reservoir and storing the measured near-wellbore data in one or more databases;

present graphically to a user simulated interwell data generated by a reservoir simulation based at least in part on the measured near-wellbore data;

overlay graphically at least some of the measured near-wellbore data over the simulated interwell data;

present graphically to the user one or more production indicators (270, 272, 274, 276) calculated based at least in part on the simulated interwell data;

determine a deviation of at least one production indicator (270, 272, 274, 276) from a reference value;

identify and present to the user a recommended action applicable to one or more of the plurality of wells (240, 242) to correct the deviation, if said deviation exceeds a threshold value,

wherein the simulated interwell data includes data near and at a distance from the plurality of wells (240, 242).

10. The system of claim 9, wherein the simulated interwell data comprises water saturation levels.

11. The system of claim 9 or 10, wherein the at least some of the measured near-wellbore data comprises water cuts or oil cuts for each of one or more producer wells of the plurality of wells.

12. The system of claim 9, 10 or 11, wherein the one or more production indicators (270, 272, 274, 276) comprise an indicator selected from the group consisting of a voidage replacement ratio, a nominal pressure, a volumetric sweep efficiency and a displacement efficiency.

13. The system of claim 9, 10, 11 or 12, wherein the software further causes the one or more processors to present one or more alarms to the user if a production indicator deviates from the or another reference value by more than the or another threshold value.

14. The system of any one of claims 9 to 13, wherein the software further causes the one or more processors to perform the overlay in real-time as the measured near-wellbore data is collected.

**Patentansprüche**

1. Verfahren zum Überwachen und Diagnostizieren eines Reservoirs, das Folgendes umfasst:

   Sammlung von Messdaten in der Nähe eines Bohrlochs, die für Bedingungen an oder nahe einer Mehrzahl von Bohrlöchern innerhalb des Reservoirs repräsentativ sind, und Speicherung der Messdaten in der Nähe eines Bohrlochs in einer oder mehreren Datenbanken;
   grafische Darstellung von simulierten internen Bohrlochdaten an einen Benutzer, die durch eine Reservoirsimulation zumindest teilweise auf Basis der Messdaten in der Nähe eines Bohrlochs erzeugt werden;
   grafische Überlagerung von mindestens einigen der Messdaten in der Nähe eines Bohrlochs über die simulierten internen Bohrlochdaten;
   grafische Darstellung eines oder mehrerer Produktionsindikatoren (270, 272, 274, 276) an den Benutzer, die zumindest teilweise auf Basis der simulierten internen Bohrlochdaten berechnet wurden;
   Bestimmung einer Abweichung mindestens eines Produktionsindikators (270, 272, 274, 276) von einem Referenzwert; und
   Identifizierung und Darstellung einer empfohlenen Aktion an den Benutzer, die für eines oder mehrere der Mehrzahl von Bohrlöchern (240, 242) anwendbar ist, um die Abweichung zu korrigieren, falls die Abweichung einen Schwellenwert überschreitet,
   wobei die simulierten internen Bohrlochdaten Daten nahe und in einem Abstand von der Mehrzahl von Bohrlöchern (240, 242) enthalten.

2. Verfahren nach Anspruch 1, wobei die simulierten internen Bohrlochdaten Wassersättigungsniveaus umfassen.

3. Verfahren nach Anspruch 1 oder 2, wobei die zumindest einigen der Messdaten in der Nähe eines Bohrlochs Wassergehalt oder Ölgehalt für jedes von einer oder mehreren Förderbohrungen (202-218, 214-226, 224-236) der Mehrzahl von Bohrlöchern umfassen.

4. Verfahren nach Anspruch 1, 2 oder 3, wobei der eine oder die mehreren Produktionsindikatoren (270, 272, 274, 276) einen Indikator umfassen, der aus der Gruppe ausgewählt ist, die aus einem Lückenersatzverhältnis, einem Nenndruck, einem volumetrischen Durchlaufwirkungsgrad und einem Verschiebungswirkungsgrad besteht.

5. Verfahren nach einem der vorstehenden Ansprüche, weiter die Darstellung eines oder mehrerer Alarme für den Benutzer umfassend, wenn ein Produktionsindikator (270, 272, 274, 276) um mehr als den oder einen anderen Schwellenwert von dem oder einem anderen Referenzwert abweicht.

6. Verfahren nach einem der vorstehenden Ansprüche, wobei die Überlagerung in Echtzeit durchgeführt wird, wenn die Messdaten in der Nähe eines Bohrlochs gesammelt werden.

7. Verfahren nach einem der vorstehenden Ansprüche, weiter das Starten der Reservoirsimulation zumindest teilweise auf Basis von einem gespeicherten Simulationsendzustand einer vorherigen Ausführung der Reservoirsimulation umfassend.

8. Verfahren nach einem der vorstehenden Ansprüche, weiter das Auswählen eines Reservoirmusters umfassend, das die Mehrzahl von Bohrlöchern (240, 242) umfasst, wobei die dem Benutzer dargestellten Produktionsindikatoren (270, 272, 274, 276) einem oder mehreren Bohrlöchern innerhalb des ausgewählten Musters entsprechen.

9. Reservoirüberwachungs- und -diagnosesystem, das Folgendes umfasst:

einen Speicher der eine Software zur Überwachung und Diagnose von Reservoiren aufweist; und

einen oder mehrere Prozessoren, die mit dem Speicher verbunden sind, wobei die Software den einen oder die mehreren Prozessoren zu Folgendem veranlasst:

Messdaten in der Nähe eines Bohrlochs, die für Bedingungen an oder nahe einer Mehrzahl von Bohrlöchern (240, 242) innerhalb des Reservoirs repräsentativ sind, zu sammeln und die Messdaten in der Nähe eines Bohrlochs in einer oder mehreren Datenbanken zu speichern;

einem Benutzer simulierte interne Bohrlochdaten grafisch darzustellen, die durch eine Reservoirsimulation zumindest teilweise auf Basis der Messdaten in der Nähe eines Bohrlochs erzeugt werden;

zumindest einige der Messdaten in der Nähe eines Bohrlochs über die simulierten internen Bohrlochdaten grafisch zu überlagern;

dem Benutzer grafisch einen oder mehrere Produktionsindikatoren (270, 272, 274, 276) darzustellen, die zumindest teilweise auf Basis der simulierten internen Bohrlochdaten berechnet werden;

eine Abweichung von zumindest einem Produktionsindikator (270, 272, 274, 276) von einem Referenzwert zu bestimmen;

eine empfohlene Aktion, die für eines oder mehrere der Mehrzahl von Bohrlöchern (240, 242) anwendbar ist, zu identifizieren und dem Benutzer darzustellen, um die Abweichung zu korrigieren, wenn die Abweichung einen Schwellenwert überschreitet,

wobei die simulierten internen Bohrlochdaten Daten nahe und in einem Abstand von der Mehrzahl von Bohrlöchern (240, 242) enthalten.

**10.** System nach Anspruch 9, wobei die simulierten internen Bohrlochdaten Wassersättigungsniveaus umfassen.

**11.** System nach Anspruch 9 oder 10, wobei die zumindest einigen der Messdaten in der Nähe eines Bohrlochs Wassergehalt oder Ölgehalt für jede von einer oder mehreren Förderbohrungen der Mehrzahl von Bohrlöchern umfassen.

**12.** System nach Anspruch 9, 10 oder 11, wobei der eine oder die mehreren Produktionsindikatoren (270, 272, 274, 276) einen Indikator umfassen, der aus der Gruppe ausgewählt ist, die aus einem Lückenersatzverhältnis, einem Nenndruck, einem volumetrischen Durchlaufwirkungsgrad und einem Verschiebungswirkungsgrad besteht.

**13.** System nach Anspruch 9, 10, 11 oder 12, wobei die Software weiter veranlasst, dass der eine oder die mehreren Prozessoren dem Benutzer einen oder mehrere Alarme darstellen, wenn ein Produktionsindikator um mehr als den oder einen anderen Schwellenwert von dem oder einem anderen Referenzwert abweicht.

**14.** System nach einem der Ansprüche 9 bis 13, wobei die Software weiter veranlasst, dass der eine oder die mehreren Prozessoren die Überlagerung in Echtzeit durchführen, wenn die Messdaten in der Nähe eines Bohrlochs gesammelt werden.

**Revendications**

**1.** Procédé de surveillance et de diagnostic d'un réservoir qui comprend :

la collecte de données de proximité de puits de forage mesurées représentatives de conditions au niveau ou à proximité d'une pluralité de puits au sein du réservoir et le stockage des données de proximité de puits de forage mesurées dans une ou plusieurs bases de données ;

la présentation graphique à un utilisateur de données interpuits simulées générées par une simulation de réservoir d'après au moins en partie les données de proximité de puits de forage mesurées ;

le recouvrement graphique d'au moins certaines des données de proximité de puits de forage mesurées sur les données interpuits simulées ;

la présentation graphique à l'utilisateur d'un ou de plusieurs indicateurs de production (270, 272, 274, 276) calculés d'après au moins en partie les données interpuits simulées ;

la détermination d'un écart d'au moins un indicateur de production (270, 272, 274, 276) par rapport à une valeur de référence ; et

l'identification et la présentation à l'utilisateur d'une action recommandée applicable à un ou plusieurs de la pluralité de puits (240, 242) pour corriger l'écart, si ledit écart dépasse une valeur seuil,

dans lequel les données interpuits simulées comportent des données de proximité et à une distance de la pluralité de puits (240, 242).

**2.** Procédé selon la revendication 1, dans lequel les données interpuits simulées comprennent des niveaux de saturation d'eau.

**3.** Procédé selon la revendication 1 ou 2, dans lequel les au moins certaines des données de proximité de puits de forage mesurées comprennent des proportions d'eau ou des proportions de pétrole pour chacun d'un ou de plusieurs puits de production (202 à 218, 214 à 226, 224 à 236) de la pluralité de puits.

**4.** Procédé selon la revendication 1, 2 ou 3, dans lequel les un ou plusieurs indicateurs de production (270, 272, 274, 276) comprennent un indicateur choisi dans le groupe constitué d'un rapport de remplacement de porosité, d'une pression nominale, d'une efficacité volumétrique de balayage et d'une efficacité de déplacement.

**5.** Procédé selon l'une quelconque des revendications précédentes, comprenant en outre la présentation d'une ou de plusieurs alarmes à l'utilisateur si un indicateur de production (270, 272, 274, 276) s'écarte de la valeur de référence ou d'une autre valeur de référence de plus de la valeur seuil ou d'une autre valeur seuil.

**6.** Procédé selon l'une quelconque des revendications précédentes, dans lequel le recouvrement est réalisé en temps réel lorsque les données de proximité de puits de forage mesurées sont collectées.

**7.** Procédé selon l'une quelconque des revendications précédentes, comprenant en outre le démarrage de la simulation de réservoir d'après au moins en partie un état de fin de simulation stocké d'une exécution préalable de la simulation de réservoir.

**8.** Procédé selon l'une quelconque des revendications précédentes, comprenant en outre la sélection d'un schéma de réservoir comprenant la pluralité de puits (240, 242), dans lequel les indicateurs de production (270, 272, 274, 276) présentés à l'utilisateur correspondent à un ou plusieurs puits au sein du schéma sélectionné.

**9.** Système de surveillance et de diagnostic de réservoir qui comprend :

une mémoire ayant un logiciel de surveillance et de diagnostic de réservoir ; et
un ou plusieurs processeurs couplés à la mémoire, le logiciel amenant les un ou plusieurs processeurs à :

collecter des données de proximité de puits de forage mesurées représentatives de conditions au niveau ou à proximité d'une pluralité de puits (240, 242) au sein du réservoir et stocker les données de proximité de puits de forage mesurées dans une ou plusieurs bases de données ;
présenter graphiquement à un utilisateur des données interpuits simulées générées par une simulation de réservoir d'après au moins en partie les données de proximité de puits de forage mesurées ;
recouvrir graphiquement au moins certaines des données de proximité de puits de forage mesurées sur les données interpuits simulées ;
présenter graphiquement à l'utilisateur un ou plusieurs indicateurs de production (270, 272, 274, 276) calculés d'après au moins en partie les données interpuits simulées ;
déterminer un écart d'au moins un indicateur de production (270, 272, 274, 276) par rapport à une valeur de référence ;
identifier et présenter à l'utilisateur une action recommandée applicable à un ou plusieurs de la pluralité de puits (240, 242) pour corriger l'écart, si ledit écart dépasse une valeur seuil,
dans lequel les données interpuits simulées comportent des données de proximité et à une distance de la pluralité de puits (240, 242).

**10.** Système selon la revendication 9, dans lequel les données interpuits simulées comprennent des niveaux de saturation d'eau.

**11.** Système selon la revendication 9 ou 10, dans lequel les au moins certaines des données de proximité de puits de forage mesurées comprennent des proportions d'eau ou des proportions de pétrole pour chacun d'un ou de plusieurs puits de production de la pluralité de puits.

**12.** Système selon la revendication 9, 10 ou 11, dans lequel les un ou plusieurs indicateurs de production (270, 272, 274, 276) comprennent un indicateur choisi dans le groupe constitué d'un rapport de remplacement de porosité, d'une pression nominale, d'une efficacité volumétrique de balayage et d'une efficacité de déplacement.

**13.** Système selon la revendication 9, 10, 11 ou 12, dans lequel le logiciel amène en outre les un ou plusieurs processeurs à présenter une ou plusieurs alarmes à l'utilisateur si un indicateur de production s'écarte de la valeur de référence ou d'une autre valeur de référence de plus de la valeur seuil ou d'une autre valeur seuil.

**14.** Système selon l'une quelconque des revendications 9 à 13, dans lequel le logiciel amène en outre les un ou plusieurs processeurs à réaliser le recouvrement en temps réel lorsque les données de proximité de puits de forage mesurées sont collectées.

# FIG. 1

# FIG. 2

270 **Voidage Replacement**
0.31

272 **Nominal Pressure**
1

274 **Volumetric Efficiency**
0.25

276 **Displacement Efficiency**
0.03

Producer

Injector

Water Saturation: □ 0.00  ▤ 0.50  ■ 1.00
▦ 0.25  ▨ 0.75

Well-by-well Near-wellbore
Production Data

300

302 Real-Time DB

306 Historical DB

Historical Data

Periodic Consolidated Calcs — 308

Raw Prod Data

304 Production Data Processing

Consolidated Data

Full Physics Simulation — 314

Processed Production Data

320 User I/F Display

Simulation Data

Simulation Results DB — 316

KPI Gauge Data

Saturation Map Data

Saturation Data

Selected Sim Results Data

310 Water Saturation Map Generation

318 Analytical Simulation & KPI Generation

# FIG. 3

400

Collect Well-by-Well Near-wellbore Reservoir Data and Store in Real-time and Historical Databases | 402

Process Near-wellbore Production Data | 404

Calculate Consolidated Data from Historical Data | 406

Run Full Physics Simulations against Historical Data | 408

Generate Water Saturation Map Data from Simulation Results | 410

Graphically Present Water Saturation Map for Reservoir | 412

Overlay Processed Prod. Data onto Water Saturation Map | 414

Run Analytical Simulation against Selected Full Physics Simulation Results & Calculate Key Performance Indicators | 416

Graphically Present Key Performance Indicators | 418

Done | 420

# FIG. 4

Well-by-Well Near-wellbore Data

510

Data Acquisition Subsystem

Data Storage Subsystem 520

General Purpose Digital Data Processing Subsystem

530

| Data Collection/Storage Module | 532 |
| Prod. Data Processing Module | 534 |
| Consolidated Calculation Module | 536 |
| Map Gen & Presentation Module | 538 |
| Overlay Module | 540 |
| Analytical Sim & KPI Calc Module | 542 |
| KPI Presentation Module | 544 |
| Deviation Detection Module | 546 |

Full-Physics Simulation Module

535

User I/F Subsystem 550

500

# FIG. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20090107669 A1
- US 20110040543 A1